# EUROPEAN PATENT APPLICATION

(11) **EP 2 100 934 A1**
(43) Date of publication of application: **16.09.2009**
(21) Application number: 07859882.8
(22) Date of filing: 20.12.2007
(51) Int. Cl.: C09J 7/02, C09J 11/06, C09J 133/06, H01L 21/301

(54) **PRESSURE SENSITIVE ADHESIVE SHEET FOR SEMICONDUCTOR SUBSTRATE PROCESSING**

(30) Priority: 05.01.2007 JP 2007000362
(71) Applicant: Nitto Denko Corporation, Ibaraki-shi Osaka 567-8680 (JP)
(72) Inventor: SHINTANI, Toshio, Ibaraki-shi Osaka 567-8680 (JP); YAMAMOTO, Akiyoshi, Ibaraki-shi Osaka 567-8680 (JP); ASAI, Fumiteru, Ibaraki-shi Osaka 567-8680 (JP); HASHIMOTO, Kouichi, Ibaraki-shi Osaka 567-8680 (JP)
(74) Representative: Hager, Thomas Johannes
(86) International application number: PCT/JP2007/074485
(87) International publication number: WO 2008/081725

(57) **Abstract**

An object of the present invention is to provide a stable adhesive sheet in which the disappearance of the laser-printings prevents almost entirely, without leaving adhesive residue whatsoever during the cut of the substrate. An adhesive sheet for processing semiconductor substrates comprises a UV rays- and/or radiation-transmittable base film and an adhesive layer that undergoes a polymerization curing reaction by means of UV rays and/or radiation, wherein the adhesive layer has a thickness of 7 to 15 µm.

## Description

### [Technical Field]

The present invention relates to an adhesive sheet for processing semiconductor substrates, and more particularly to an adhesive sheet for processing semiconductor substrates comprising a base film and an adhesive layer containing specific ingredients.

### [Background Art]

An adhesive sheet for processing semiconductor wafers and/or substrates are conventionally used to secure semiconductor wafers and/or substrates when the semiconductor wafers and/or substrates are diced and expanded, and the semiconductor wafers and/or substrates are then picked up and simultaneously mounted.

In this type of sheet, a UV- and/or radiation-transmittable base film is coated with an adhesive layer that undergoes a polymerization curing reaction by means of UV rays and/or radiation, and the adhesive layer is irradiated with UV rays and/or radiation after the dicing process, causing the adhesive layer to undergo a polymerization curing reaction, whereby the adhesive strength is reduced, allowing the individual pieces such as the semiconductor wafers, chips, or substrates to be picked up.

An adhesive sheet for semiconductor wafer processing has been proposed as this type of sheet, for example, the adhesive layer comprises a base polymer, a multifunctional urethane acrylate having a molecular weight of 15,000 to 50,000, a polyester plasticizer, and a photopolymerization initiator, where the polyester plasticizer is included in a proportion of 1 to 50 weight parts per 100 weight parts base polymer (see Patent document 1, for example). The use of multifunctional urethane acrylate oligomers having a molecular weight of about 3,000 to 10,000 for the adhesive layer has also been proposed (see Patent Document 2, for example).

Recently, however, in packages in which substrates with semiconductor chips or the like mounted thereon are sealed with resin, the substrates having printings by laser light to a depth of between 10 and 40 µm on the sealed resin surface where the adhesive tape is to be applied is used. Also, a tip after the cut and/or the package miniaturize more and more.

When semiconductor substrates having such laser printings on the sealed resin surface are cut, a resin particle required for characters discrimination with conventionally used adhesive sheets is removed because of a buried adhesive to the texture of the laser printings by pressure and heat during the attachment or the cut, resulting in disappearance of the printings and problems with a significant loss of yield.
The case that chips are wrapped on roll trays is increasing as the package miniaturizes, whereas, an adhesive residue on the side surface of the chips occurs during the cut of the substrate, using the method described above. If the chips are wrapped on the trays under this situation, this cause a problem with series of chips which is to be normally individually picked up when the chips are removed, resulting in a significant complicated processes and increased cost.
[Patent Document 1] Japanese Laid-Open Patent Application H06-49420
[Patent Document 2] Japanese Laid-Open Patent Application S62-153376

### [Disclosure of the Invention]

### [Problem to be Solved]

In view of the foregoing, an object of the present invention is to provide a stable adhesive sheet in which the disappearance of the laser-printings prevents almost entirely, without leaving adhesive residue whatsoever during the cut of the substrate.

### [Means for Solving the Problem]

The inventors led the present invention by finding a method that, with this kinds of the adhesive sheets, disappearance of the laser-printings could be prevented almost entirely, and leaving adhesive residue on the side surface of the substrate during the cut of the substrate could be prevented almost entirely, based on the conventional problem.
That is, the present invention provides an adhesive sheet for processing semiconductor substrates comprising a UV rays- and/or radiation- transmittable base film and an adhesive layer that undergoes a polymerization curing reaction by means of UV rays and/or radiation, wherein the adhesive layer has a thickness of 7 to 15 µm, and the adhesive layer includes at leaset an acrylate copolymer, and a polyisocyanate compound and/or a polyglycidyl compound and/or a melamine compound.

### [Effect of the Invention]

The adhesive sheet for processing semiconductor substrate of the invention has a thin adhesive thickness and/or high cohesion of an adhesive layer, regardless of a recess by laser-printings on the adhering surface of an adherend such as semiconductor substrate and the like to the adhesive sheet, thereby possible to provide a consistent adhesive sheet in which disappearance phenomenon of the printings by stress and heat during a series of the processes can be almost completely prevented and adhesive residue on the chip side surface can be almost completely prevented.

### [Detailed Description of the Preferred Embodiments]

The adhesive sheet for processing semiconductor substrates of the present invention mainly comprises a base film and an adhesive layer.
The base film used in the present invention is not particularly limited, provided that it may be UV- and/or radiation-transmittable. For example, it may be at least partially transmittable to radiation such as UV rays, X-rays, and electron beams. The permeability may be at least about 75%, at least about 80%, and at least about 90%, for example. Examples of the base film include a film made of a polymer or the like, for example, polyester such as polyvinyl chloride, polyvinylidene chloride, polyethylene terephthalate; polyamide, polyether ether ketone; polyolefins such as low-density polyethylene, liner polyethylene, medium-density polyethylene, high-density polyethylene, very low-density polyethylene, random copolypropylene, block copolypropylene, homopolypropylene, polybutene, polymethylpentene; polyurethane, ethylene-vinyl acetate copolymer, ionomer resin, ethylene-(meth)acrylic acid copolymer, ethylene-(meth)acrylic ester (random, alternating) copolymer, ethylene-butene copolymer, ethylene-hexene copolymer, fluorocarbon polymer, cellulosic resin or crosslinked polymer thereof. The base film may be either a single layer or a multi-layered structure of two or more layers. The thickness of the base film is generally about 5 to 400 µm, preferably 20 to 300 µm.

The adhesive layer is not particularly limited but can be used a variety of adhesives, provided that it is comprises an adhesive capable of undergoing a polymerization curing reaction by means of UV rays and/or radiation.
A commonly used pressure-sensitive adhesive can be employed as the adhesive in the present invention, and may suitably include a compound with UV- and/or radiation-curable functional groups such as carbon-carbon double bonds as a base polymer. Conventionally known base polymers for use in adhesives can be selected as desired for use as the base polymer. Examples that are suitable for use include polymers such as acrylic polymers, specifically, acrylic polymers obtained through the polymerization of (meth)acrylic acid or esters thereof and monomers or the like that are copolymerizable with (meth)acrylic acid or esters thereof, and natural or synthetic rubbers or the like. A molecular weight is preferably 300,000 to 1,500,000, or 300,000 to 1,100,000. A molecular weight that is too low tends to result in cutting displacement during the cutting process, while a molecular weight that is too great may make it difficult to achieve compatibility with the tackifier or other additives. The base polymers given in JP 3,797,601A and the Patent Documents 1 and 2 described in the prior art may also be used.

Examples of the copolymerizable monomer constituting the base polymer include hydroxylalkyl esters of (meth)acrylic acid such as hydroxyethyl ester, hydroxybutyl ester, hydroxyhexyl ester; glycidyl (meth)acrylate; monomers containing carboxylic group such as acrylic acid, methacrylic acid, carboxyethyl (meth)acrylate, carboxy pentyl (meth)acrylate, itaconic acid, maleic acid, fumaric acid, crotonic acid; acid anhydride monomers such as maleic anhydride, itaconic anhydride; (meth)acrylamide; (meth)acrylate N-hydroxymethylamide; (meth)acrylate alkylaminoalkylester such as dimethylaminoethyl methacrylate, t-butyl aminoehtyl methacrylate; N-vinylpyrrolidone; acryloyl morpholine; vinyl acetate; styrene; acrylonitrile; N,N-dimethylacrylamide; monomers containing alkoxyl group at side chain such as methoxyethyl (meth)acrylate, ethoxy (meth)acrylate; or the like. These copolymerizable monomers can be used alone or as mixture of more than two components.

Regardless of whether the base polymer does or does not have intramolecular carbon-carbon double bonds, it may include any components having carbon-carbon double bonds, monofunctional or multifunctional components, or mixtures thereof. It will preferably include multifunctional and/or UV- (radiation-) curable components to bring about cross linking. Examples of such component include (meth)acrylate oligomers and monomers.
Examples of that include hexanediol di(meth)acrylate, polyethylene glycol di(meth)acrylate, 1,4-butanediol di(meth)acrylate, polypropylene glycol di(meth)acrylate, neopentylglycol di(meth)acrylate, pentaerythritol di(meth)acrylate, trimethylolpropane tri(meth)acrylate, pentaerythritol tri(meth)acrylate, pentaerythritol tetra(meth)acrylate, dipentaerythritol monohydroxy penta(meth)acrylate, dipentaerythritol hexa(meth)acrylate, epoxy(meth)acrylate, polyester (meth)acrylate, urethane (meth)acrylate or the like, and various oligomers such as urethane-based, polyether-based, polyester-based, polycarbonate-based, or polybutadiene-based oligomers are also included, suitably with a molecular weight in the range of about 100 to 30,000. These components can be used alone or as mixture of more than two components.

Urethane (meth)acrylate oligomers in particular may preferably have 2 to 4, and further 2 acryloyl groups per molecule. These oligomers can be produced, for example, by first reacting between a diisocyanate and polyol in a reactor kept at 60 to 90°C, and then adding a hydroxy (meth)acrylate after the conclusion of the reaction to bring about another reaction.
Examples of diisocyanate include toluene diisocyanate, diphenylmethane diisocyanate, hexamethylene diisocyanate, phenylene diisocyanate, dicyclohexylmethane diisocyanate, xylene diisocyanate, tetramethylxylene diisocyanate, naphthalene diisocyanate, or the like, for example.
Examples of polyol include ethylene glycol, propylene glycol, butanediol, hexanediol, or the like, for example.
Examples of hydroxy(meth)acrylate include 2-hydroxyethyl (meth)acrylate, 2-hydroxypropyl(meth)acrylate, or the like, for example.

Examples of elastomer used as the base polymer include natural rubbers, synthetic isoprene rubber, styrene-butadiene rubber, styrene-butadiene-styrene block copolymer, styrene-isoprene-styrene block copolymer, butyl rubber, polyisobutylene, polybutadiene, polyvinyl ether, silicone rubber, polyvinyl isobutyl ether, vinyl acetate polymer, chloroprene rubber, nitrile rubber, graft rubber, reclaimed rubber, styrene-ethylene-butylene block copolymer, styrene-propylene-butylene block copolymer, styrene-isoprene copolymer, acrylonitrile-butadiene copolymer, acrylonitrile-acrylate copolymer, methyl-methacrylate -butadiene copolymer, polyisobutylene-ethylene-propylene copolymer, ethylene-vinyl acetate copolymer, or acrylic rubber such as alkyl acrylate copolymer, alkyl acrylate-alkoxy alkyl acrylate copolymer, or the like.

A cross linker may be added as desired, particularly when an acrylic polymer is used as the base polymer in the present invention. Cross linkers can bring about three-dimensional cross linking of the base polymer, further enhancing the cohesive strength of the adhesive layer. Examples of the cross linker include any conventional compounds such as polyisocyanate compounds, polyglycidyl compounds, melamine compounds, aziridine compounds, polyvalent metal chelate compounds. Among these, it is preferably to add singly, or 2 or more of polyisocyanate compounds, polyglycidyl compounds, aziridine compounds, and melamine compounds. In particularly, it is more preferably to add singly, or 2 or more of polyisocyanate compounds, polyglycidyl compounds, and melamine compounds with an acrylate copolymer described above as the adhesive. These compounds are usually used for enhancing the cohesive strength of the adhesive layer. Using these compounds can result in preventing the disappearance of the laser-printings and leaving no adhesive residue on a chip side.
The proportion in which the cross linker is blended when added may be 0.01 to 8 weigh parts, preferably 0.03 to 5 weigh parts per 100 weight parts base polymer. When the cross linker is blended in a proportion that is too low, the addition of the cross linker will not produce enough cohesive, whereas too much will result in free residue in the adhesive layer, causing the contamination of the semiconductor substrates.

The adhesive layer of the adhesive sheets of the present invention may optionally comprise at least one conventional additive such as tackifiers, surfactants, multifunctional components curable by irradiation of UV rays. Further, it may be comprise at least one of softening agents, antioxidants, curing agents, fillers, UV absorbers, photostabilizers, (photo)polymerization initiators and the like.

The tackifier may preferably have a hydroxyl value of 120 to 230 mg/g, more preferably 120 to 210 mg/g. The hydroxyl value that is too great or too low tends not to result in enough adhesion on the sealing resin before UV irradiation. The adhesive strength also tends not to be lowered to the desired level after UV irradiation, depending on the type of sealing resin or the like on the adhering surface of the adhesive sheet or when there is not enough release agent added to or adhering to the resin surface.

The tackifier may be preferably used in an amount of 0.1 to 70 parts, and 1 to 50 parts per 100 (weight) parts base polymer. Too low a proportion of tackifier will result in less of an increase in the adhesive strength, whereas too much tends to result in a tackifier with less storage stability of the adhesive sheets, making it difficult to achieve long-term stability.

Examples of the tackifier that include hydroxyl groups and have the specified hydroxyl value include terpene phenolic resins, rosin phenolic resins, alkylphenolic resins or the like.
Examples of the terpene phenolic resin include alpha-pinene -phenolic reisn, beta-pinene-phenolic reisn, dipentene-phenolic resin, terpenebisphenolic resin or the like. Because terpene phenolic resins can be used to achieve high compatibility with the base polymer, stable quality can be preserved over long periods of time, with virtually no changes in the quality during tape storage.
The tackifier usually has a lower molecular weight than the base polymer. For example, the molecular weight is in the tens of thousands or less, ten thousands or less, a few thousand or less. The tackifier can be used alone or mixtures of two or more.

Any ionic or nonionic surfactant can be used as the surfactant. Examples of the surfactant include ester-types, ether types, polyoxyethylene alkyl ethers, polyoxyethylene alkyl phenyl ethers, polyethyleneglycols, carboxylic-types, sulfonic-types, amino acid-types, amine-types or the like. From the standpoint of compatibility in the adhesive, a molecular weight of no more than 2000, and no more than 1500 is preferred. However, this limit does no apply when the molecular structure has good affinity for the adhesive. Antistatic effects can be provided, particularly when quaternary ammonium salts are used. These can be single types alone or mixtures of two or more.

Among these, ester types are preferred, that is, those including ester compounds or derivatives thereof, preferably with a carbon number of 10 or more. It is possible to both prevent flick and achieve good pick up of adherends with low amounts of a release agent on the surface. Further, ester compounds with an alkyl group of a carbon number of 15 or more are preferred. The carbon number of the alkyl groups of the compounds that is too low tends to result in a low initial adhesive strength of the adhesive which includes this. The maximum carbon number is suitably about 50 to 60 in the interests of industrial availability, molecular weight distribution, heat resistance (that is, a maximum melting point of about 110°C), and the like. The melting point of such ester compounds may be preferably at least 40°C to ensure stability during long-term storage at elevated temperatures. As a result, the adhesive properties will be prevented from increasing even when sheets involving the use of the adhesive composition of the invention as the adhesive layer are applied to adherends and stored for long periods of time at elevated temperatures.

Examples of such ester compound include ester compounds (monoesters, diesters, triesters, or the like) of higher alcohols with alkyl groups having a carbon number of at least 10, and preferably at least 15, and acids such as a carboxylic acid, sulfuric acid, sulfurous acid, phosphoric acid, phosphorous acid, or the like. Among these, monoesters, diesters, or trimesters of higher alcohols and phosphoric acid are preferably used. Examples of the higher alcohol include stearyl alcohol (carbon number: 18), 1-docosanol (carbon number:22), 1-tetracosanol (carbon number:24), 1-hexacosanol (carbon number:26), 1-octacosanol (carbon number:28), 1-nonacosanol (carbon number:29), myricyl alcohol (carbon number:30), hentriacontanol (carbon number:31), lacceryl alcohol (carbon number:32), cellomelissyl alcohol (carbon number:33), 1-tetratriacontanol (carbon number:34), 1-pentatriacontanol (carbon number:35), 1-tetratetracontanol (carbon number:44), and the like, for example. Examples of the acid include monocarboxylic acid such as formic acid, acetic acid, benzoic acid; polycarboxylic acid such as oxalic acid, succinic acid, tricarballylic acid, and the like.

Ester compounds of higher alcohols can be produced by heating a higher alcohol and an acid such as a carboxylic acid, sulfuric acid, sulfurous acid, phosphoric acid, or phosphorous acid to reflux in the presence of an acid catalyst such as hydrochloric acid in an organic solvent, and dehydrating the water that is produced. Ester compounds of alcohols and carboxylic acids having alkyl groups with a carbon number of at least 10, and preferably at least 15, can also be used as ester compounds or derivatives thereof.
Other types of commercially available surfactants that will not cause contamination during the semiconductor process can also be selected as desired for use.

In the present invention, the surfactant such as the ester compound or derivative thereof may be blended in an amount of 0.02 to 8 weight parts, and more preferably 0.05 to 2 weight parts, per 100 weight parts base polymer. With an amount that is too low, substantially no effects can be expected when the surfactant is added, whereas adding too much will result in a low initial adhesive strength before UV irradiation, with little hope of the product functioning as an adhesive composition, and the poor compatibility with the adhesive may result in contamination of the adherend surface after being removed. The surfactant can be used single type alone or as mixture of more than two components.

Examples of the softening agent include plasticizer, polybutene, liquid tackifier resins, polyisobutylene lower polymer, polyvinyl isobutyl ether lower polymer, lanolin, depolymerization rubber, processing oil, vulcanized oil or the like, for example. The softening agent can be used single type alone or as mixture of more than two components.

Examples of the antioxidant include phenol antioxidant such as 2,6-di tert-butyl-4-methylphenol, 1,1-bis-(4-hydroxyphenol) cyclohexane; amine antioxidant such as phenyl β-naphthylamine; benzimidazole antioxidant such as mercaptbenzimidazole; 2,5-di tert-butylhydroquinone, or the like. The antioxidant can be used single type alone or as mixture of more than two components.

Examples of the curing agent for the rubber adhesive include isocyanate, sulfur-curable and vulcanization accelerator, polyalkylphenol, organic peroxide, or the like. Examples of the isocyanate include phenylene diisocyanate, tolylene diisocyanate, diphenylmetha diisocyanate, hexamethylene diisocyanate, cyclohexane diisocyanate, or the like. Examples of the sulfur-curable and vulcanization accelerator include thiazole rubber accelerator, sulfenic amide rubber accelerator, thiuram rubber accelerator, dithioate rubber accelerator, or the like. Examples of the polyalkylphenol include butyl phenol, octyl phenol, nonyl phenol, or the like. Examples of the organic peroxide include dichromyl peroxide, ketone peroxide, peroxy ketal, hydroperoxide, dialkyl peroxide, peroxyester, peroxy dicarbonate, or the like. The curing agent can be used single type alone or as mixture of more than two components.

Examples of the filler include hydrozincite, titanium oxide, silica, aluminium hydroxide, calcium carbonate, barium sulfate, starch, clay, talc, or the like. The filler can be used single type alone or as mixture of more than two components.

The photopolymerization initiator is excited and activated by the irradiation of ultraviolet rays, and generates radicals, thereby curing polyfunctional oligomers by radical polymerization. Examples of the photopolymerization initiator include acetophenone compounds such as 4-phenoxy dichloroacetophenon, 4-t-butyl dichloroacetophenon, diethoxyacetophenon, 2-hydroxy-2-methyl-1-phenyl puropane-1-one, 1-(4-isopropylphenyl)-2-hydroxy-2-methylpropane-1-one, 1-(4-dodecylphenyl)-2-hydroxy-2-methylpropane-1-one, 4-(2-hydroxyethoxy) phenyl-(2-hydroxy-2-propyl) ketone, 1-hydroxycyclohexyl phenyl ketone, 2-methyl-1-[4-(methyltio)phenyl] -2-morpholinoprophane-1; benzoine compounds such as benzoine, benzoine methylether, benzoine ethylether, benzoine isopropylether, benzoine isobutylether, 2,2-dimethoxy-2-phenylacetophenon; benzophenone compounds such as benzophenone, benzoylbenzoate, benzoyl methyl benzoate, 4-phenyl benzophenone, hydroxyl benzophenone, 4-benzoyl-4'-methyldiphenyl sulfide, 3,3'-dimethyl-4 -methoxybenzophenone; thioxanthone compounds such as thioxanthone, 2-chlorthioxanthone, 2-methylthioxanthone, 2,4-dimethyl thioxanthone, isopropyl thioxanthone, 2,4-dichloro thioxanthone, 2,4-diethyl thioxanthone, 2,4-diisopuropyl thioxanthone; specific photopolymerization initiator such as α-acyloxym ester, acyl phosphine oxide, methylphenyl glyoxylate, benzil, camphorchinone, dibenzosuberone, 2-ethyl anthraquinone, 4',4"-diethlisophthalophenone, and the like

The photopolymerization initiator may be blended in a proportion of 0.1 to 15 weight parts, preferably 0.5 to 10 weight parts, per 100 weight parts base polymer. Too low a proportion of photopolymerization initiator will result in less of curing function to the multifunctional oligomers or monomers with UV rays- and/or radiation, and less enough in a reducing adhesive strength, whereas too much results in less heat or fluorescent light stability. The photopolymerization initiator can be used single type alone or as mixture of more than two components.

Examples of the polymerization initiator include peroxides such as hydrogen peroxide, benzoyl peroxide, t-butyl peroxide, or the like. One may be preferably used by itself, or it may be combined with a reducing agent and used as a redox type of polymerization initiator. Examples of the reducing agent include ionic salts such as salts of iron, copper, cobalt, sulfite, bisulfite; amines such as triethanol amine; reducing sugar such as aldose, ketose, or the like. Also, azo compounds such as 2,2'-azobis-2-methylpropioamidine salt, 2,2'-azobis-2,4-dimethylvaleronitrile, 2,2'-azobis-N,N'-dimethyleneisobutylamidine salt, 2,2'-azobisisobutyronitrile, 2,2'-azobis-2-methyl-N-(2-hydroxyethyl) propionamide may be used. These can be used single type alone or as mixture of more than two components.

Examples of method for forming the adhesive layer on the base film to produce the adhesive sheet for processing semiconductor wafers or semiconductor substrates include methods in which the components forming the adhesive layer are dissolved as such or by a suitable organic solvent, applied onto the base film by being coated, dispersed, or the like, and dried by a heat treatment or the like for 30 seconds to 10 minutes at 80 to 100°C.
The thickness of the adhesive layer is preferable 7 to 15 µm, and more preferable 8 to 15 µm. The thickness departing from this range tends to increase disappearance of the laser-printing, and to leave slightly the adhesive residue on the side surface of the chip due to an adhesive inclusion by a blade when cut even though the adhesive layer with a high cohesive. Also, it results in causing a new problem such as chip fly when cut due to a reducing of contact area and an inability to conform sufficiently to the resin surface.

The adhesive sheet for processing semiconductor wafer and/or processing substrates in the present invention can be used in commonly employed methods. For example, semiconductor wafers and/or substrates may be applied and secured, and the semiconductor wafers and/or substrates may then be cut into element pieces (chips) by a rotating circular blade. The pieces are then irradiated with UV rays and/or radiation through the base film side of the adhesive sheet for processing, the adhesive sheet is then radially expanded using a special jig, widening the gaps between the element pieces (chips) to regular intervals, the element pieces (chips) are then poked out by needles or the like, and they are adsorbed or the like by an air pin set or the like, so as to be picked up and simultaneously mounted.
The adhesive sheet of the invention can also be used for a variety of adherends, such as semiconductor wafers, semiconductor substrates, and sealed resin substrates in which one or more chips or the like are individually or integrally sealed with leads and sealing resin or the like. The adherend that is attached is not limited to semiconductors but can be a variety of materials, that is inorganics such as metal, plastic, glass, ceramics, or the like. The adhesive sheet of the invention is particularly suitable for use with objects such as those with a laser-printed adhering surface on the surface.

The adhesive sheet of the present invention is illustrated in greater detail by, but is not limited to, the following examples and comparative examples.

### Example 1

100 weight parts copolymer (35% of solid content) having weight-average molecular weight of 700000 and copolymerized by methyl acrylate / acrylic acid / 2-ethylhexyl acrylate at weight ratio of 20/10/80;
100 weight parts multifunctional acrylate oligomer (UV-1700, made by Nippon Gohsei), and
25 weight parts terpene phenolic resin (YS polyster-N125, made by Yasuhara Chemical Co., Ltd.) as a tackifier,
0.01 weight parts melamine compound (J-820-60N, made by Dainippon ink and chemicals Inc.) as a cross linker, and
5 weight parts photopolymerization initiator (Irgacure 651, made by Ciba Specialty Chemicals)
was mixed to prepare a resin solution to be an adhesive layer.
The resin solution was applied to a dry thickness of 7 µm on a 38 µm thick polyester film which had undergone silicone release treatment, and was dried for 5 minutes at 150°C.
The 150 µm polyethylene film serving as the base film was then laminated, giving a semiconductor processing sheet.
The resulting semiconductor wafer processing sheet was aged for at least 4 days at 50°C, and was evaluated in the following manner. The results are given in Table 1.

### Example 2

An adhesive sheet was prepared in the same manner as in Example 1 except that the resin solution was applied to a dry thickness of 13 µm when the adhesive sheet of Example 1 was prepared. The sheet was evaluated in the following manner.

### Example 3

An adhesive sheet was prepared in the same manner as in Example 1 except that the adhesive composition was prepared adding 0.02 weight parts glycidyl compound (TETRAD-C, made by Mitsubisi Gas Chemical Company Inc.) as a cross linker when the adhesive solution of Example 1 was prepared, and the resin solution was applied to a dry thickness of 15 µm. The sheet was evaluated in the following manner.

### Example 4

An adhesive sheet was prepared in the same manner as in Example 1 except that the adhesive composition was prepared adding 0.03 weight parts the cross linker when the adhesive solution of Example 1 was prepared, and the resin solution was applied to a dry thickness of 15 µm. The sheet was evaluated in the following manner.

### Example 5

An adhesive sheet was prepared in the same manner as in Example 1 except that the adhesive composition was prepared adding 5 weight parts polyisocyanate compound (CORONATE-L, made by NIPPON POLYIRETHAN INDUSTRY Co., Ltd.) as a cross linker when the adhesive solution of Example 1 was prepared, and the resin solution was applied to a dry thickness of 15 µm. The sheet was evaluated in the following manner.

### Example 6

An adhesive sheet was prepared in the same manner as in Example 1 except that the adhesive composition was prepared adding 8 weight parts polyisocyanate compound (CORONATE-L, made by NIPPON POLYIRETHAN INDUSTRY Co., Ltd.) as a cross linker when the adhesive solution of Example 1 was prepared, and the resin solution was applied to a dry thickness of 15 µm. The sheet was evaluated in the following manner.

### Example 7

An adhesive sheet was prepared in the same manner as in Example 6 except that the resin solution was applied to a dry thickness of 7 µm when the adhesive sheet of Example 6 was prepared. The sheet was evaluated in the following manner.

### Example 8

An adhesive sheet was prepared in the same manner as in Example 4 except that the resin solution was applied to a dry thickness of 7 µm when the adhesive sheet of Example 4 was prepared. The sheet was evaluated in the following manner.

### Example 9

An adhesive sheet was prepared in the same manner as in Example 6 except that the resin solution was applied to a dry thickness of 20 µm when the adhesive solution of Example 6 was prepared. The sheet was evaluated in the following manner.

### Example 10

An adhesive sheet was prepared in the same manner as in Example 4 except that the resin solution was applied to a dry thickness of 20 µm when the adhesive solution of Example 4 was prepared. The sheet was evaluated in the following manner.

### Example 11

An adhesive sheet was prepared in the same manner as in Example 1 except that the adhesive composition was prepared adding 0.006 weight parts glycidyl compound (TETRAD-C, made by Mitsubisi Gas Chemical Company Inc.) as a cross linker when the adhesive solution of Example 1 was prepared, and the resin solution was applied to a dry thickness of 15 µm. The sheet was evaluated in the following manner.

### Example 12

An adhesive sheet was prepared in the same manner as in Example 11 except that the resin solution was applied to a dry thickness of 725 µm when the adhesive sheet of Example 11 was prepared. The sheet was evaluated in the following manner.

### Example 13

An adhesive sheet was prepared in the same manner as in Example 1 except that the resin solution was applied to a dry thickness of 6 µm when the adhesive sheet of Example 1 was prepared. The sheet was evaluated in the following manner.

### Example 14

An adhesive sheet was prepared in the same manner as in Example 7 except that the resin solution was applied to a dry thickness of 6 µm when the adhesive sheet of Example 7 was prepared. The sheet was evaluated in the following manner.

### Comparative Example 1

An adhesive sheet was prepared in the same manner as in Example 9 except that the resin solution was applied to a dry thickness of 25 µm when the adhesive sheet of Example 9 was prepared. The sheet was evaluated in the following manner.

### Comparative Example 2

An adhesive sheet was prepared in the same manner as in Example 10 except that the resin solution was applied to a dry thickness of 25 µm when the adhesive sheet of Example 10 was prepared. The sheet was evaluated in the following manner.

### Comparative Example 3

An adhesive sheet was prepared in the same manner as in Example 1 except that the adhesive composition was prepared adding 0.002 weight parts polyisocyanate compound (CORONATE-HL, made by NIPPON POLYIRETHAN INDUSTRY Co., Ltd.) as a cross linker when the adhesive solution of Example 1 was prepared, and the resin solution was applied to a dry thickness of 15 µm. The sheet was evaluated in the following manner.

### Comparative Example 4

An adhesive sheet was prepared in the same manner as in Comparative Example 3 except that the resin solution was applied to a dry thickness of 5 µm when the adhesive sheet of Comparative Example 3 was prepared. The sheet was evaluated in the following manner.

### Comparative Example 5

An adhesive sheet was prepared in the same manner as in Example 1 except that the resin solution was applied to a dry thickness of 5 µm when the adhesive sheet of Example 1 was prepared. The sheet was evaluated in the following manner.

### Comparative Example 6

An adhesive sheet was prepared in the same manner as in Example 7 except that the resin solution was applied to a dry thickness of 5 µm when the adhesive solution of Example 7 was prepared. The sheet was evaluated in the following manner.

### Application of Tape

The adhesive sheets prepared in the Examples and Comparative Examples were applied at a speed of 20 mm/sec and a table temperature of 55°C using a Nitto Seiki M-286N applicator to the sealed resin surface of substrates in which semiconductor chips had been embedded (laser -printing to a depth of 15µm in the resin surface).

### Cut

The adhesive layer and base film were cut to a cut depth of 90 µm using a DISCO DFG-651 dicer and a resin blade with a blade speed of 38,000 rpm and a blade thickness of 300 µm under conditions involving a speed of 40 mm/sec and a cutting water quantity of 1.5 L/min. At this time, the 5000 packages were checked for adhesive residue on the side surface of the package and disappearance of the laser-printings.

The results are shown in Table 1 and Table 2.

**Table 1**

| | Example | | | | | | | |
|---|---|---|---|---|---|---|---|---|
| | 1 | 2 | 3 | 4 | 5 | 6 | 7 | 8 |
| Adhesive Layer | 7 | 13 3 | 15 | 15 | 15 | 15 | 7 | 7 |
| Thickness | µm | µm | µm | µm | µm | µm | µm | µm |
| Disappearance of | 0 % | 0 % | 0 % | 0 % | 0 % | 0 % | 0 % | 0 % |
| Laser-Printings | | | | | | | | |
| Adhesive Residue | 0 % | 0 % | 0 % | 0 % | 0 % | 0 % | 0 % | 0 % |
| on the Side | | | | | | | | |
| Surface | | | | | | | | |
| Chip Fly | 0% | 0% | 0% | 0% | 0% | 0% | 0% | 0% |

**Table 2**

| | Comparative Example | | | | | | | |
|---|---|---|---|---|---|---|---|---|
| | 1 | 2 | 3 | 4 | 5 | 6 | 7 | 8 |
| Adhesive Layer | 25 | 25 | 15 | 5 | 5 | 5 | 20 | 20 |
| Thickness | µm | µm | µm | µm | µm | µm | µm | µm |
| Disappearance | 12 % | 16 % | 10 % | 1 % | 0 % | 0 % | 0.1 % | 0.14 % |
| of | | | | | | | | |
| Laser-Printings | | | | | | | | |
| Adhesive | 4 % | 8 % | 9 % | 3 % | 0 % | 0 % | 0.05% | 0.02 % |
| Residue on the | | | | | | | | |
| Side Surface | | | | | | | | |
| Chip Fly | 0 % | 0 % | 0 % | 8 % | 25 % | 40 % | 0 % | 0% |

### [Industrial Field of the Invention]

The present invention can be utilized in a wide range of any kinds of applications such that it is applied to semiconductor wafers (such as silicon wafer, germanium wafer, gallium arsenide wafer), circuit boards, ceramic substrates, metal substrates, semiconductor packages and the like.

## Claims

1. An adhesive sheet for processing semiconductor substrates comprising a UV rays- and/or radiation-transmittable base film and an adhesive layer that undergoes a polymerization curing reaction by means of UV rays and/or radiation,
wherein the adhesive layer has a thickness of 7 to 15 µm.

2. The adhesive sheet according to Claim 1, wherein the adhesive layer is made of at least an acrylate copolymer as well as a polyisocyanate compound and/or polyglycidyl compound and/or melamine compound.
